# EUROPEAN PATENT APPLICATION

(11) **EP 2 451 260 A1**
(43) Date of publication of application: **09.05.2012**
(21) Application number: 09846806.9
(22) Date of filing: 30.06.2009
(51) Int. Cl.: H05K 5/03, E05D 11/06, F16C 11/04

(54) **HOUSING FOR POWER CONDITIONER**

(71) Applicant: Mitsubishi Electric Corporation, Tokyo 100-8310 (JP)
(72) Inventor: YASUE, Takashi, Tokyo 102-0073 (JP); NISHIO, Kenji, Tokyo 102-0073 (JP); NAKABAYASHI, Hirokazu, Tokyo 100-8310 (JP); YATO, Tadashi, Nakatsugawa-shi Gifu 508-0041 (JP)
(74) Representative: Pfenning, Meinig & Partner GbR
(86) International application number: PCT/JP2009/061973
(87) International publication number: WO 2011/001513

(57) **Abstract**

A casing 1 for a power conditioner includes a casing body, a door 11, a bearing shaft 13, a bearing 14, a pin 16, and a guide hole 17. The bearing 14 supports the bearing shaft 13 such that the bearing shaft 13 can pivot about a pivot axis RL and can move in the direction of the pivot axis RL. The pin 16 is provided to one of the bearing shaft 13 and the bearing 14, and projects toward the other one of the bearing shaft 13 and the bearing 14. The guide hole 17 is formed in any of the bearing shaft 13 and the bearing 14 that is not provided with the pin 16, and is in engagement with the pin 16. The guide hole 17 includes an axial guide hole 17a and a circumferential guide hole 17b. The axial guide hole 17a is formed in the direction of the pivot axis RL. The circumferential guide hole 17b is formed to intersect with the axial guide hole 17a while extending in a circumferential direction. The circumferential guide hole 17b allows the pin 16 to move relative to the guide hole 17 in the circumferential direction when the door 11 is opened.

## Description

### Field

The present invention relates to a casing for a power conditioner, the casing housing units of a power conditioner.

### Background

Conventional casings for housing units include a casing with a casing body to which a door is connected such that the door can move pivotally relative to the casing body. The door of this type may be shaken while it is closed when the casing is placed, for example, in the open air where the casing is exposed to wind. A technique for suppressing the shaking of the door is disclosed, for example, in Patent Literature 1. Patent Literature 1 discloses a shake absorber for a folding door that is attached to a door with two folding panels in a pair. A recess and a projection are formed to face each other at abutting lower parts of the rear sides of the two folding panels. The shake absorber includes a recessed latch and a projecting latch that are brought into close engagement when the two folding panels are closed.

### Citation List

### Patent Literature

Patent Literature 1: Japanese Patent Application Laid-open No. H10-299332

### Summary

### Technical Problem

A casing may be exposed to rain as well as wind if it is placed in the open air. Accordingly, a casing to be placed in the open air should be protected from ingress of water into a casing body. Thus, it would be considered that the casing to be placed in the open air may have a structure for protecting from ingress of water into a casing body that is realized, for example, by providing a rain shielding part for covering a gap between a door and the casing body to the casing body such that it projects toward the door.

However, in the casing of this structure, the door interferes with the rain shielding part when the door is opened and closed. Accordingly, the conventional casing for a power conditioner to be placed in the open air is not configured such that a door pivots about a pivot axis, but such that the door can be removed completely from the casing body. In this structure, the door is attached to the casing body with bolts after units of a power conditioner are stored in the casing body. In the case of this casing, a user should unfasten all the bolts to remove the door from the casing body in order to open the door. Accordingly, the aforementioned casing may require more user's efforts for opening and closing the door.

The present invention has been made in view of the aforementioned problems. It is an object of the invention to obtain a casing for a power conditioner capable of reducing user's efforts for opening and closing a door.

### Summary

### Technical Problem

In order to solve the above-mentioned problem and achieve the object, a casing for a power conditioner according to the present invention, includes a casing body with an opening, the casing body housing units of a power conditioner, a door attached to the casing body, the door being capable of covering the opening, a bearing shaft provided to any of the casing body and the door, a bearing provided to any of the casing body and the door to which the bearing is not provided, the bearing covering at least a part of an outer circumference surface of the bearing shaft, the bearing supporting the bearing shaft such that the bearing shaft can pivot about a pivot axis of the bearing shaft and can move in a direction of the pivot axis, a projection provided to one of the bearing shaft and the bearing, the projection projecting toward the other one of the bearing shaft and the bearing, and a guide means provided to any of the bearing shaft and the bearing to which the projection is not provided, the guide means being in engagement with the projection, the guide means including, an axial portion formed in the direction of the pivot axis, and a circumferential portion formed to extend in a circumferential direction of any of the bearing shaft and the bearing in which the guide means is formed and to intersect with the axial portion, the circumferential portion allowing the projection to move relative to the guide means in the circumferential direction when the door is opened.

### Advantageous Effects of Invention

The present invention can reduce user's efforts for opening and closing the door.

### Brief Description of Drawings

FIG. 1 is a front view showing a casing for a power conditioner according to a first embodiment when a door is closed.
FIG. 2 is a front view showing the casing for a power conditioner according to the first embodiment when the door is open.
FIG. 3 is a sectional view of a hinge portion according to the first embodiment while the door is open where the hinge portion is cut along a virtual plane perpendicular to a pivot axis.
FIG. 4 is a sectional view showing the hinge portion according to the first embodiment while the door is closed, wherein the hinge portion is cut along a virtual plane perpendicular to the pivot axis.
FIG. 5 is a perspective view schematically showing a guide mechanism of the first embodiment in an enlarged manner.
FIG. 6 is a perspective view schematically showing a guide mechanism of a second embodiment in an enlarged manner.
FIG. 7 is a perspective view schematically showing a guide mechanism of a third embodiment in an enlarged manner.
FIG. 8 is a sectional view of a hinge portion according to a fourth embodiment, wherein the hinge portion is cut along a virtual plane perpendicular to a pivot axis.
FIG. 9 is a perspective view schematically showing a guide slot of the fourth embodiment in an enlarged manner.
FIG. 10 is a perspective view schematically showing a guide mechanism of a fifth embodiment in an enlarged manner.
FIG. 11 is a perspective view schematically showing a guide mechanism of a sixth embodiment in an enlarged manner. Description of Embodiments

Embodiments of a casing for a power conditioner according to the present invention will be described in detail below based on the drawings. The embodiments are not intended to limit the invention.

### First Embodiment

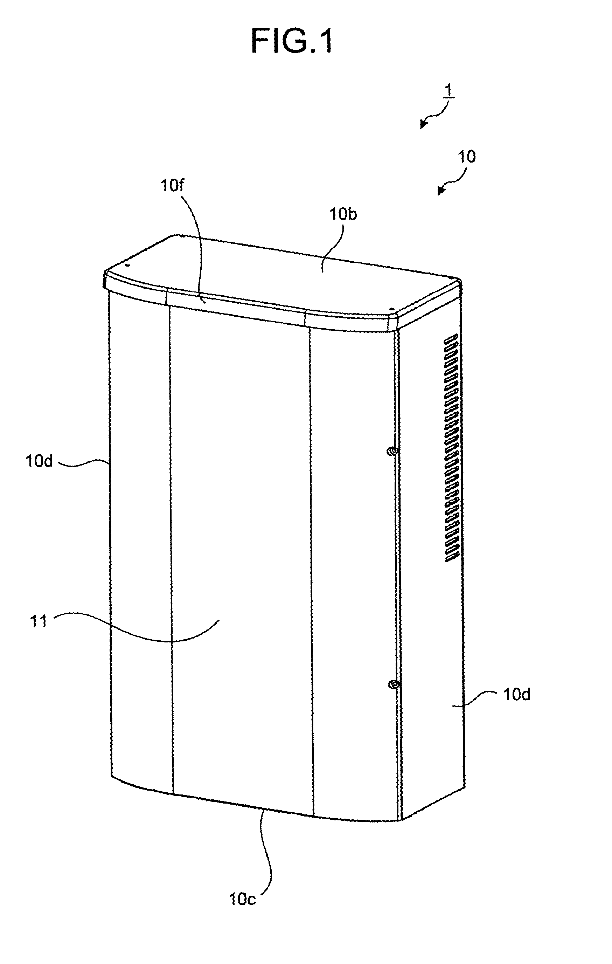

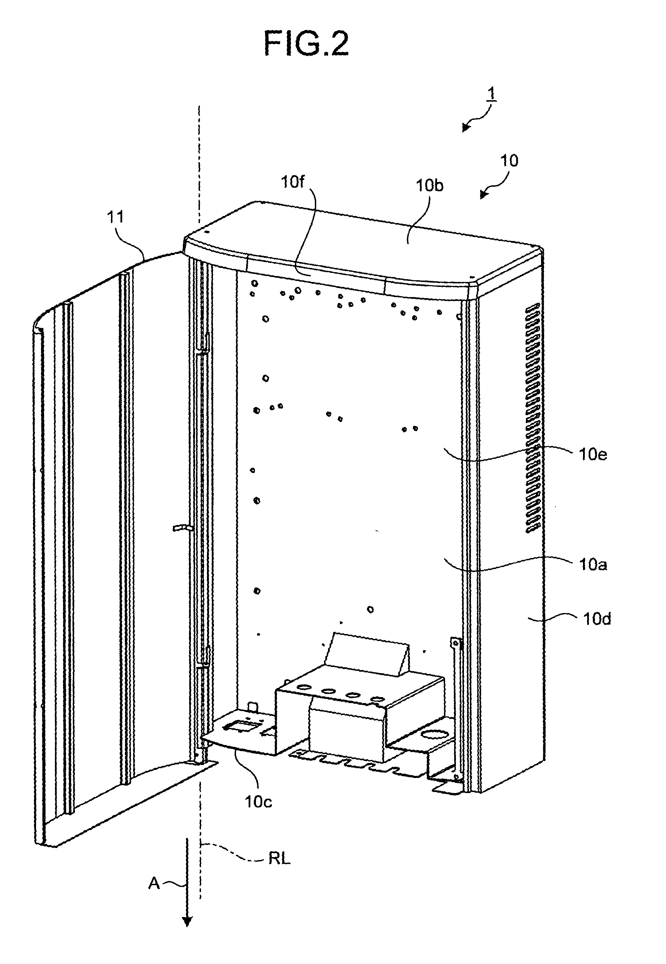

FIG. 1 is a front view showing a casing for a power conditioner according to a first embodiment when a door is closed. FIG. 2 is a front view showing the casing for a power conditioner according to the first embodiment when the door is open. As shown in FIGS. 1 and 2, a casing 1 for a power conditioner according to the first embodiment includes a casing body 10 and a door 11. The casing body 10 is composed of a back plate 10a, a top plate 10b, a bottom plate 10c, and two side plates 10d. The top plate 10b, the bottom plate 10c, and the two side plates 10d are arranged on the same side of the back plate 10a to extend, for example, perpendicularly to the side. The top and bottom plates 10b and 10c are arranged to face each other. The two side plates 10d are arranged to face each other.

The casing body 10 is formed into a box with an opening 10e defined by the back plate 10a, the top plate 10b, the bottom plate 10c, and the two side plates 10d. The opening 10e is an opening surrounded by the end portion of the top plate 10b opposite to the back plate 10a, by the end portion of the bottom plate 10c opposite to the back plate 10a, and by the end portions of the side plates 10d opposite to the back plate 10a. The casing 1 for a power conditioner stores units of a power conditioner in the casing body 10 in the form of a box.

The door 11 is coupled to one of the two side plates 10d such that it can pivot about a pivot axis RL. In the present embodiment, the pivot axis RL is perpendicular to the top and bottom plates 10b and 10c. In the casing 1 for a power conditioner, the pivotal movement of the door 11 about the pivot axis RL causes the door 11 to cover the opening 10e as shown in FIG. 1, or to expose the opening 10e as shown in FIG. 2. Hereinbelow, a state where the opening 10e is covered with the door 11 is called a state where a door is closed, and a state where the opening 10e is exposed is called a state where the door is open. The structure of a joining portion between the door 11 and the casing body 10, namely of a hinge portion will be described next.

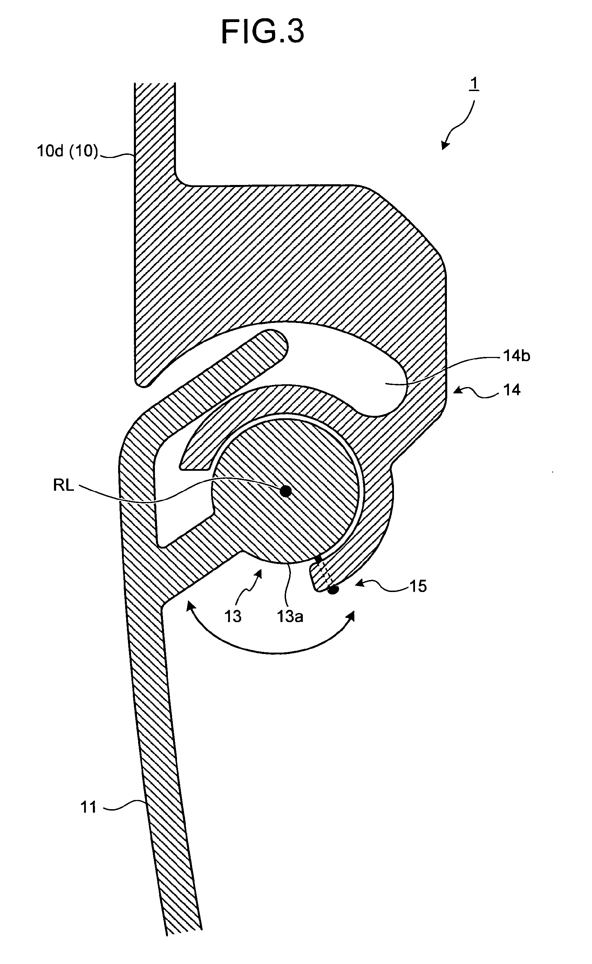

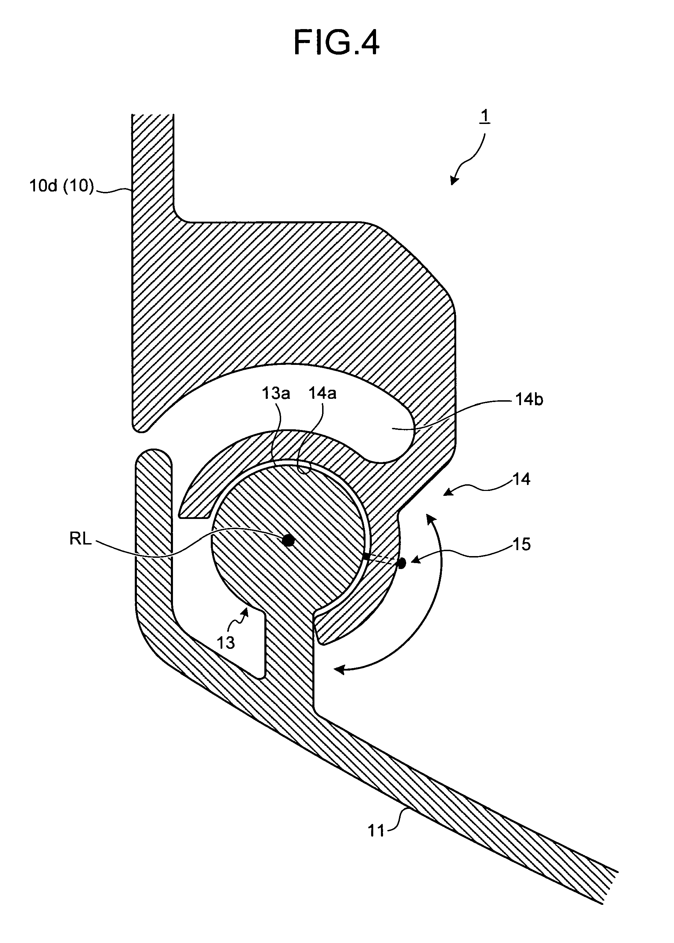

FIG. 3 is a sectional view showing the hinge portion according to the first embodiment while the door is open, wherein the hinge portion is cut along a virtual plane perpendicular to the pivot axis. FIG. 4 is a sectional view showing the hinge portion according to the first embodiment while the door is closed, wherein the hinge portion is cut along a virtual plane perpendicular to the pivot axis. As shown in FIGS. 3 and 4, the hinge portion of the casing 1 for a power conditioner is composed of a bearing shaft 13, and a bearing 14.

The bearing shaft 13 is circular in cross section cut along a virtual plane perpendicular to the pivot axis RL. Hereinbelow, a cross section cut along a virtual plane perpendicular to the pivot axis RL is simply called a cross section. The pivot axis RL passes through the center of the cross section of the bearing shaft 13. In the present embodiment, the bearing shaft 13 is provided to the door 11. The bearing 14 has such a shape that the bearing 14 covers at least part of an outer circumference surface 13a of the bearing shaft 13. In the present embodiment, the bearing 14 is formed into a tubular shape with a missing part thereof corresponding to a joining portion between the bearing shaft 13 and the door 11. Accordingly, the bearing 14 is substantially C-shaped in cross section. In the present embodiment, the bearing 14 is provided to the casing body 10.

In the casing 1 for a power conditioner, the bearing shaft 13 is inserted into the internal space of the bearing 14. The internal space mentioned here is a space surrounded by the C-shaped portion of the bearing 14 that is substantially C-shaped in cross section. This causes an inner circumference surface 14a of the bearing 14 and the outer circumference surface 13a of the bearing shaft 13 to face each other in the casing 1 for a power conditioner. Accordingly, in the casing 1 for a power conditioner, the bearing shaft 13 is supported by the bearing 14 such that the bearing shaft 13 can pivot in a circumferential direction about the pivot axis RL. As a result, the casing 1 for a power conditioner can support the door 11 with the hinge portion such that the door 11 can be opened and closed relative to the casing body 10.

In the casing 1 for a power conditioner of the aforementioned structure, the bearing shaft 13 is supported by the bearing 14 such that the bearing shaft 13 can move relative to the bearing 14 in the direction of the pivot axis RL. As a result, the casing 1 for a power conditioner can support the door 11 with the hinge portion such that the door 11 can move relative to the casing body 10 in the direction of the pivot axis RL. Here, the bearing shaft 13 is provided to the door 11 and the bearing 14 is provided to the casing body 10. However, the hinge portion is not limited to this particular structure. The structure of the hinge portion may also be configured such that the bearing shaft 13 is provided to the casing body 10 the bearing 14 is provided to the door 11.

In the casing 1 for a power conditioner, part of the door 11 may interfere with the bearing 14 or the casing body 10 while the door 11 is open. In this case, the hinge portion is provided with a clearance 14b at the bearing 14 or the casing body 10. The clearance 14b is to receive a part of the door 11 and to let the part of the door 11 in and out when the door 11 is opened and closed as shown in FIG. 3.

The casing 1 for a power conditioner is designed in consideration of the probability of being placed in the open air. Accordingly, the casing 1 for a power conditioner is provided with a rain shielding part 10f at the end portion of the top plate 10b opposite to the back plate 10a as shown in FIGS. 1 and 2. The rain shielding part 10f projects toward the bottom plate 10c, and is formed, for example, by bending the top plate 10b. This causes the rain shielding part 10f to cover a gap between the door 11 and the top plate 10b in the casing 1 for a power conditioner while the door 11 is closed. Thus, the casing 1 for a power conditioner can eliminate the possibility of ingress of water into the casing body 10 through the gap between the door 11 and the top plate 10b.

In the casing 1 for a power conditioner with the aforementioned structure, the bearing shaft 13 is supported by the bearing 14 such that the bearing shaft 13 can move relative to the bearing 14 in the direction of the pivot axis RL. As a result, the casing 1 for a power conditioner allows the door 11 to move in the direction of the pivot axis RL so that the door 11 and the rain shielding part 10f do not interfere with each other when the door 11 is opened. A direction of the pivot axis RL, in which the door 11 moves away from the rain shielding part 10f is defined as a predetermined direction A as shown in FIG. 2. In the casing 1 for a power conditioner, in order to open the door 11, the door 11 first is moved in the predetermined direction A to a position at which the door 11 does not interfere with the rain shielding part 10f. Next, in the casing 1 for a power conditioner, the door 11 pivots about the pivot axis RL to open the door 11. The casing 1 for a power conditioner has a guide mechanism 15 for regulating the movement of the door 11. The structure of the guide mechanism 15 will be described below.

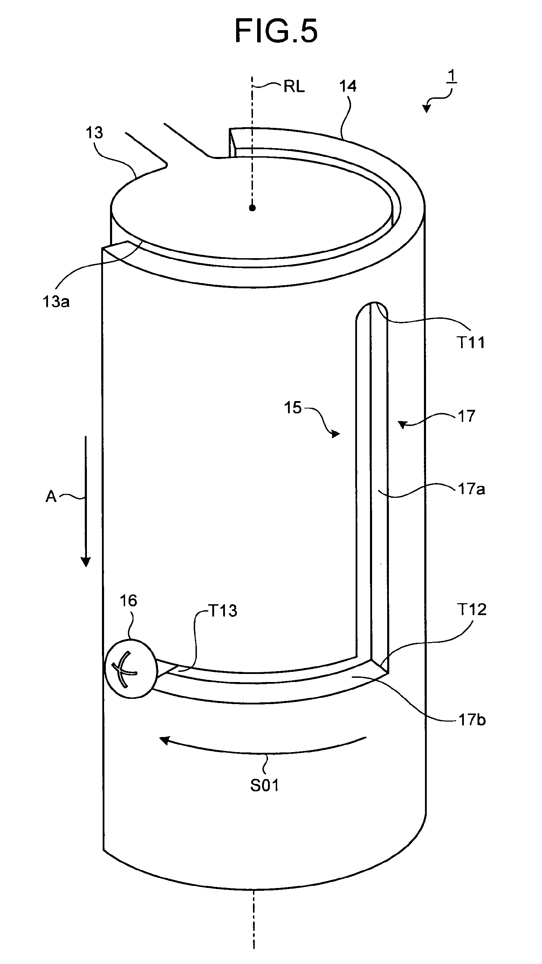

FIG. 5 is a perspective view schematically showing the guide mechanism of the first embodiment in an enlarged manner. At least one guide mechanism 15 is provided at the hinge portion between the door 11 and the casing body 10. In the present embodiment, two guide mechanisms 15 are provided at the hinge portion between the door 11 and the casing body 10 as shown in FIG. 2. As shown in FIG. 5, the guide mechanism 15 is composed of a pin 16, and a guide hole 17 as guide means in engagement with the pin 16.

In the present embodiment, the pin 16 is provided to the bearing shaft 13. The pin 16 is a projection projecting outward in the direction of the radius of the bearing shaft 13 from the outer circumference surface 13a of the bearing shaft 13 toward the bearing 14. The pin 16 may be a bolt, for example. The pin 16 of the present embodiment is not male threaded in a section to engage with the guide hole 17. Namely, the pin 16 is male threaded only in a tip end section. This prevents reduction of durability of the guide hole 17 due to the engagement of a male threaded section of a pin 16 with a guide hole 17. In the guide mechanism 15 of the present embodiment, a female thread hole is formed in the outer circumference surface 13a of the bearing shaft 13. The male threaded section formed in the pin 16 is inserted into this female thread hole formed in the outer circumference surface 13a of the bearing shaft 13, thereby attaching the pin 16 to the bearing shaft 13.

The guide hole 17 is formed in the bearing 14. The guide hole 17 is a hole penetrating the bearing 14 in the direction of the radius of the bearing 14. The guide hole 17 is composed of an axial guide hole 17a as an axial portion of the guide means, and a circumferential guide hole 17b as a circumferential portion of the guide means. The axial guide hole 17a forms a part of the guide hole 17, and is a portion parallel to the pivot axis RL. The circumferential guide hole 17b forms a part of the guide hole 17, and is a portion formed to extend in the circumferential direction of the bearing 14. A description will be given of the structure of the lateral circumferential side of the bearing 14 expanded on a plane. The circumferential direction mentioned here includes not only a direction perpendicular to the axial guide hole 17a but also a direction tilted relative to the axial guide hole 17a.

The axial and circumferential guide holes 17a and 17b of the guide hole 17 intersect with each other while they communicate with each other. In the present embodiment, the axial and circumferential guide holes 17a and 17b of the guide hole 17 are perpendicular to each other, whereby the guide hole 17 has a substantially L-shaped configuration. In the casing 1 for a power conditioner, the pivotal movement of the door 11 about the pivot axis RL causes the bearing shaft 13 to pivot about the pivot axis RL, thereby causing the pin 16 attached to the bearing shaft 13 to pivot about the pivot axis RL. A circumferential direction, in which the door 11 pivots to open the door 11 is defined as a door pivoting direction S01. In the present embodiment, the pin 16 is coupled to the bearing shaft 13 and pivots together with the door 11. Accordingly, the door pivoting direction S01 coincides with a direction in which the pin 16 is caused to move when the door 11 is opened. The circumferential guide hole 17b is formed to extend from the axial guide hole 17a toward the door pivoting direction S01.

A description will be given of the direction of mounting the guide mechanism 15. First, in the casing 1 for a power conditioner, the bearing shaft 13 is attached to the bearing 14 before the pin 16 is attached to the bearing shaft 13. Next, in the casing 1 for a power conditioner, the position of the bearing shaft 13 inside the bearing 14 is determined such that the female thread hole formed in the outer circumference surface 13a of the bearing shaft 13 and the guide hole 17 face each other. Then, in the casing 1 for a power conditioner, the pin 16 is inserted through the guide hole 17 toward the pivot axis RL into the female thread hole formed in the outer circumference surface 13a of the bearing shaft 13. As a result, the guide mechanism 15 is mounted to the casing 1 for a power conditioner.

The action and the effect of the guide mechanism 15 will next be described. A part of the guide hole 17 corresponding to a closed end portion of the axial guide hole 17a is defined as a first end portion T11. A part of the guide hole 17 corresponding to a portion at which the axial and circumferential guide holes 17a and 17b communicate with each other is defined as an intersecting portion T12. Further, a part of the guide hole 17 corresponding to a closed end portion of the circumferential guide hole 17b is defined as a second end portion T13. The first end portion T11 is formed closer to the rain shielding part 10f shown in FIG. 1 than the intersecting portion T12. The second end portion T13 is formed away from the intersecting portion T12 in the door pivoting direction S01.

In the guide mechanism 15, the pin 16 engages with the guide hole 17 at the first end portion T11 while the door 11 is closed. If a user tries to move the door 11 pivotally about the pivot axis RL, since the pin 16 engages with the axial guide hole 17a in the casing 1 for a power conditioner, the movement of the pin 16 in the door pivoting direction S01 is regulated by the axial guide hole 17a in the casing 1 for a power conditioner. As a result, the door 11 does not pivot about the pivot axis RL in the casing 1 for a power conditioner, whereby the casing 1 for a power conditioner can avoid interference between the door 11 and the rain shielding part 10f shown in FIG. 1.

A user applies force to the door 11 in the predetermined direction A in the direction of the pivot axis RL in order to open the door 11. At that time, the pin 16 moves along the axial guide hole 17a toward the circumferential guide hole 17b. That is, the pin 16 moves in the predetermined direction A from the first end portion T11 toward the intersecting portion T12. In the casing 1 for a power conditioner, the pin 16 engages with the circumferential guide hole 17b when the pin 16 reaches the intersecting portion T12. This prevents the pin 16 from moving further in the predetermined direction A. Accordingly, the casing 1 for a power conditioner can limit the amount of movement of the door 11 in the predetermined direction A.

Next, the user causes the door 11 to pivot about the pivot axis RL in the door pivoting direction S01. At that time, the pin 16 moves along the circumferential guide hole 17b in the door pivoting direction S01 from the intersecting portion T12 toward the second end portion T13. In the casing 1 for a power conditioner, the second end portion T13 regulates the movement of the pin 16 in the door pivoting direction S01 after the pin 16 reaches the second end portion T13. As a result, the casing 1 for a power conditioner can limit the amount of pivotal movement of the door 11 in the door pivoting direction S01.

As described above, the casing 1 for a power conditioner includes the axial guide hole 17a, and the circumferential guide hole 17b that is formed to extend in the door pivoting direction S01 in which the pin 16 is caused to move relative the guide hole 17 for opening the door 11. Accordingly, in the casing 1 for a power conditioner, the axial guide hole 17a guides the bearing shaft 13 first such that the door 11 is caused to move toward the predetermined direction A.

Next, in the casing 1 for a power conditioner, the circumferential guide hole 17b allows the pin 16 to move toward the opening direction S01. To be specific, in the casing 1 for a power conditioner, the circumferential guide hole 17b guides the bearing shaft 13 such that the door 11 is caused to pivot toward the door pivoting direction S01. Thus, the casing 1 for a power conditioner can avoid interference between the door 11 and the rain shielding part 10f shown in FIG. 1. As described above, even if a casing for a power conditioner includes the rain shielding part 10f shown in FIGS. 1 and 2, a user can open and close the door 11 easily without the need of removing the door 11 completely from the casing body 10. Thus, the casing 1 for a power conditioner can eliminate the possibility of increased user's efforts for opening and closing the door 11.

The casing 1 for a power conditioner is provided with the guide mechanism 15, and accordingly, can regulate the amount of movement of the door 11 in the predetermined direction A. Thus, the casing 1 for a power conditioner can prevent the excessive movement of the bearing shaft 13 in the direction of the pivot axis RL. This can eliminate the possibility of collision of the door 11 with the ground, or of the bearing shaft 13 falling off the bearing 14, for example. Further, the casing 1 for a power conditioner is provided with the guide mechanism 15, and accordingly, can regulate the amount of pivotal movement of the door 11 in the door pivoting direction S01. Thus, in the casing 1 for a power conditioner, the maximum degree of opening of the door 11 can be set.

### Second Embodiment

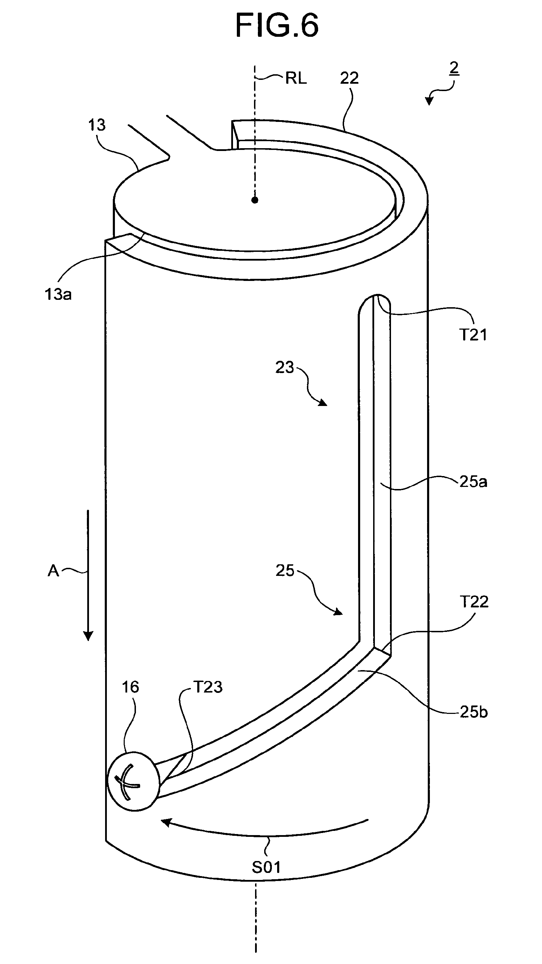

FIG. 6 is a perspective view schematically showing a guide mechanism of a second embodiment in an enlarged manner. A guide mechanism 23 of a casing 2 for a power conditioner according to the second embodiment includes a guide hole of a shape different from that of the guide mechanism 15 of the casing 1 for a power conditioner according to the first embodiment. As shown in FIG. 6, the guide mechanism 23 is composed of a pin 16, and a guide hole 25 as guide means in engagement with the pin 16. The guide hole 25 is formed in a bearing 22. The guide hole 25 is a hole penetrating the bearing 22 in the direction of the radius of the bearing 22.

The guide hole 25 is composed of an axial guide hole 25a as an axial portion of the guide means, and a circumferential guide hole 25b as a circumferential portion of the guide means. The axial guide hole 25a is formed in parallel to a pivot axis RL. The circumferential guide hole 25b is formed to extend in the circumferential direction of the bearing 22. The circumferential guide hole 25b is formed while it is tilted relative to the axial guide hole 25a. The circumferential guide hole 25b is formed from the axial guide hole 25a toward a direction midway between a door pivoting direction S01 and a predetermined direction A. The axial and circumferential guide holes 25a and 25b of the guide hole 25 intersect with each other while they communicate with each other.

The action and the effect of the guide mechanism 23 will next be described. A part of the guide hole 25 corresponding to a closed end portion of the axial guide hole 25a is defined as a first end portion T21. A part of the guide hole 25 corresponding to a portion at which the axial and circumferential guide holes 25a and 25b communicate with each other is defined as an intersecting portion T22. Further, a part of the guide hole 25 corresponding to a closed end portion of the circumferential guide hole 25b is defined as a second end portion T23. The first end portion T21 is formed closer to the rain shielding part 10f shown in FIG. 1 than the intersecting portion T22. The second end portion T23 is formed away from the intersecting portion T22 in the door pivoting direction S01, and is farther from the rain shielding part 10f than the intersecting portion T22.

In the guide mechanism 23, the pin 16 engages with the guide hole 25 at the first end portion T21 while a door 11 is closed. If a user tries to move the door 11 pivotally about the pivot axis RL, since the pin 16 engages with the axial guide hole 25a in the casing 2 for a power conditioner, the movement of the pin 16 in the door pivoting direction S01 is regulated by the axial guide hole 25a in the casing 2 for a power conditioner. As a result, the door 11 does not pivot about the pivot axis RL in the casing 2 for a power conditioner, whereby the casing 2 for a power conditioner can avoid interference between the door 11 and the rain shielding part 10f shown in FIG. 1.

A user applies force to the door 11 in the predetermined direction A in the direction of the pivot axis RL in order to open the door 11. At that time, the pin 16 moves along the axial guide hole 25a in the predetermined direction A from the first end portion T21 toward the intersecting portion T22. In the casing 2 for a power conditioner, the pin 16 engages with the circumferential guide hole 25b when the pin 16 reaches the intersecting portion T22. This prevents the pin 16 from moving further in the predetermined direction A. Accordingly, the casing 2 for a power conditioner can limit the amount of movement of the door 11 in the predetermined direction A.

Next, the user causes the door 11 to pivot about the pivot axis RL in the door pivoting direction S01. At that time, the pin 16 moves along the circumferential guide hole 25b from the intersecting portion T22 toward the second end portion T23. At that time, the door 11 pivots about the pivot axis RL in the door pivoting direction S01 while the door 11 moves toward the predetermined direction A. The casing 2 for a power conditioner has the bottom plate 10c shown in FIG. 2 that is generally placed at the lower side in the vertical direction.

Accordingly, in the casing 2 for a power conditioner, the predetermined direction A is a direction toward the lower side in the vertical direction, and accordingly, the second end portion T23 is placed at a lower side than the intersecting portion T22 in the vertical direction. Thus, in the guide mechanism 23, the pin 16 is caused to move toward the second end portion T23 by the weight of the door 11 itself while the pin 16 is guided along the circumferential guide hole 25b. As a result, the casing 2 for a power conditioner can reduce power a user applies to cause the door 11 to pivot in the door pivoting direction S01.

The intersecting portion T22 is placed at an upper side than the second end portion T23 in the vertical direction. Accordingly, in the casing 2 for a power conditioner, the pin 16 is pressed against the second end portion T23 by the weight of the door 11 itself when the pin 16 reaches the second end portion T23. This allows the guide mechanism 23 to regulate the pivotal movement of the door 11 about the pivot axis RL. Accordingly, the guide mechanism 23 can eliminate the possibility of unintentional close of the door 11 when the door 11 is open for maintenance of a power conditioner by a user (operator).

### Third Embodiment

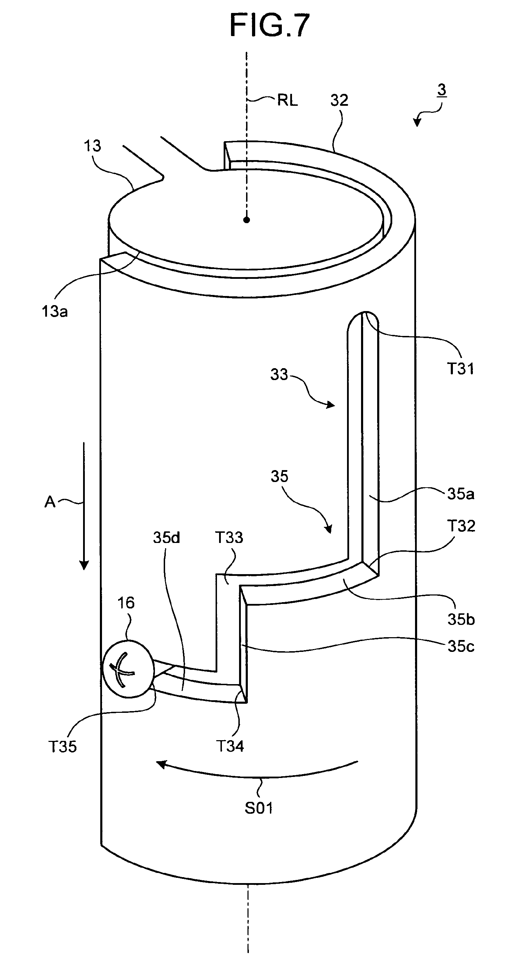

FIG. 7 is a perspective view schematically showing a guide mechanism of a third embodiment in an enlarged manner. A guide mechanism 33 of a casing 3 for a power conditioner according to the third embodiment includes a guide hole of a shape different from that of the guide mechanism 15 of the casing 1 for a power conditioner according to the first embodiment, and from that of the guide mechanism 23 of the casing 2 for a power conditioner according to the second embodiment. As shown in FIG. 7, the guide mechanism 33 is composed of a pin 16, and a guide hole 35 as guide means in engagement with the pin 16. The guide hole 35 is formed in a bearing 32. The guide hole 35 is a hole penetrating the bearing 32 in the direction of the radius of the bearing 32.

The guide hole 35 is composed of a first axial guide hole 35a as a first axial portion of the guide means, a first circumferential guide hole 35b as a first circumferential portion of the guide means, a second axial guide hole 35c as a second axial portion of the guide means, and a second circumferential guide hole 35d as a second circumferential portion of the guide means. The first and second axial guide holes 35a and 35c are formed in parallel to a pivot axis RL. The first and second axial guide holes 35a and 35c are formed at different positions in the circumferential direction of the bearing 32. In the present embodiment, the first and second axial guide holes 35a and 35c are formed in parallel to each other.

The first and second circumferential guide holes 35b and 35d are formed to extend in the circumferential direction of the bearing 32. The first and second circumferential guide holes 35b and 35d are formed at different positions in the direction of the pivot axis RL of the bearing 32. In the present embodiment, the first and second circumferential guide holes 35b and 35d are formed in parallel to each other. The first and second circumferential guide holes 35b and 35d are formed perpendicularly to the first and second axial guide holes 35a and 35c. Regarding the guide hole 35, one side of the first circumferential guide hole 35b communicates with the first axial guide hole 35a, and the opposite side of the first circumferential guide hole 35b communicates with the second axial guide hole 35c. Further, regarding the guide hole 35, one side of the second circumferential guide hole 35d communicates with the second axial guide hole 35c, and the opposite side of the second circumferential guide hole 35d is closed.

The action and the effect of the guide mechanism 33 will next be described. A part of the guide hole 35 corresponding to a closed end portion of the first axial guide hole 35a is defined as a first end portion T31. A part of the guide hole 35 corresponding to a portion at which the first axial guide hole 35a and the first circumferential guide hole 35b communicate with each other is defined as a first intersecting portion T32. A part of the guide hole 35 corresponding to a portion at which the first circumferential guide hole 35b and the second axial guide hole 35c communicate with each other is defined as a second intersecting portion T33. A part of the guide hole 35 corresponding to a portion at which the second axial guide hole 35c and the second circumferential guide hole 35d communicate with each other is defined as a third intersecting portion T34. Further, a part of the guide hole 35 corresponding to a closed end portion of the second circumferential guide hole 35d is defined as a second end portion T35.

The first end portion T31 is formed closer to the rain shielding part 10f shown in FIG. 1 than the first intersecting portion T32. The second intersecting portion T33 is formed away from the first intersecting portion T32 toward a door pivoting direction S01. The third intersecting portion T34 is formed farther from the rain shielding part 10f than the second intersecting portion T33. The second end portion T35 is formed away from the third intersecting portion T34 in the door pivoting direction S01.

In the guide mechanism 33, the pin 16 engages with the first axial guide hole 35a at the first end portion T31 while a door 11 is closed. If a user tries to move the door 11 pivotally about the pivot axis RL, since the pin 16 engages with the first axial guide hole 35a in the casing 3 for a power conditioner, the movement of the pin 16 in the door pivoting direction S01 is regulated by the first axial guide hole 35a in the casing 3 for a power conditioner. As a result, the door 11 does not pivot about the pivot axis RL in the casing 3 for a power conditioner, whereby the casing 3 for a power conditioner can avoid interference between the door 11 and the rain shielding part 10f shown in FIG. 1.

A user applies force to the door 11 in a predetermined direction A in the direction of the pivot axis RL in order to open the door 11. At that time, the pin 16 moves along the first axial guide hole 35a from the first end portion T31 toward the first intersecting portion T32. In the casing 3 for a power conditioner, the pin 16 engages with the first circumferential guide hole 35b when the pin 16 reaches the first intersecting portion T32. Next, the user causes the door 11 to pivot about the pivot axis RL in the door pivoting direction S01. By doing so, the pin 16 moves along the first circumferential guide hole 35b from the first intersecting portion T32 toward the second intersecting portion T33. At that time, the door 11 has moved in the predetermined direction A, and accordingly, the casing 3 for a power conditioner avoids interference of the door 11 with the rain shielding part 10f as shown in FIG. 2.

In the guide mechanism 33, the pin 16 engages with the second axial guide hole 35c when the pin 16 reaches the second intersecting portion T33. Then, the pin 16 moves along the second axial guide hole 35c from the second intersecting portion T33 toward the third intersecting portion T34. At that time, in the guide mechanism 33, the pin 16 is caused to move in the predetermined direction A by the weight of the door 11 itself. The user causes the door 11 to pivot about the pivot axis RL in the door pivoting direction S01 after the pin 16 reaches the third intersecting portion T34. At that time, the pin 16 moves along the second circumferential guide hole 35d from the third intersecting portion T34 toward the second end portion T35. This causes the door 11 to pivot about the pivot axis RL in the door pivoting direction S01.

In the casing 3 for a power conditioner of the aforementioned structure, the movement of the pin 16 in the circumferential direction is regulated at the second end portion T35 and the third intersecting portion T34 when the pin 16 engages with the second circumferential guide hole 35d, namely when the door 11 is open. This allows the guide mechanism 33 to regulate the pivotal movement of the door 11 about the pivot axis RL between the third intersecting portion T34 and the second end portion T35. Accordingly, the guide mechanism 33 can eliminate the possibility of unintentional close of the door 11 while the door 11 is open for maintenance of a power conditioner by a user (operator).

### Fourth Embodiment

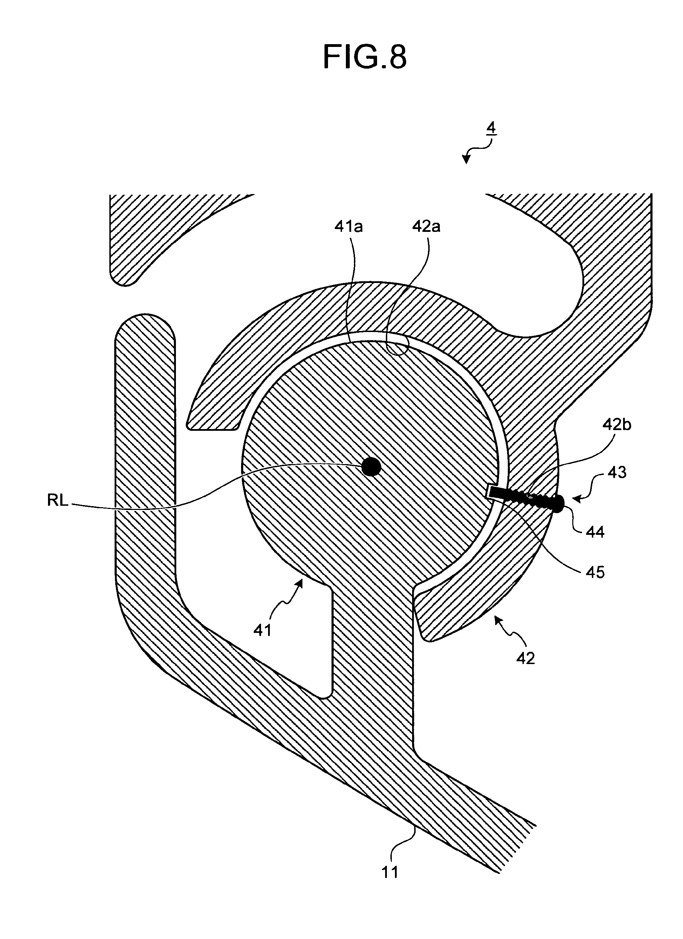

FIG. 8 is a sectional view of a hinge portion according to a fourth embodiment wherein the hinge portion is cut along a virtual plane perpendicular to a pivot axis. A guide mechanism 43 of a casing 4 for a power conditioner according to the fourth embodiment is **characterized in that** guide means is formed in a bearing shaft 41, and a pin 44 is provided to a bearing 42. As shown in FIG. 8, the guide mechanism 43 is composed of the pin 44 and a guide slot 45 as the guide means in engagement with the pin 44.

The pin 44 is provided to the bearing 42. The pin 44 is a projection projecting from the inner circumference surface 42a of the bearing 42 toward the bearing shaft 41. The pin 44 may be a bolt, for example. The pin 44 is not male threaded in a section to engage with the guide slot 45. Namely, the pin 44 is male threaded only in a root section. In the guide mechanism 43 of the present embodiment, an attachment hole 42b is formed in the bearing 42. The attachment hole 42b is a hole penetrating the bearing 42 in a radial direction. A female thread is formed in the attachment hole 42b. In the guide mechanism 43, the male threaded section of the pin 44 is screwed into the attachment hole 42b formed in the bearing 42, thereby attaching the pin 44 such that the tip end of the pin 44 projects from the inner circumference surface 42a of the bearing 42 toward the bearing shaft 41.

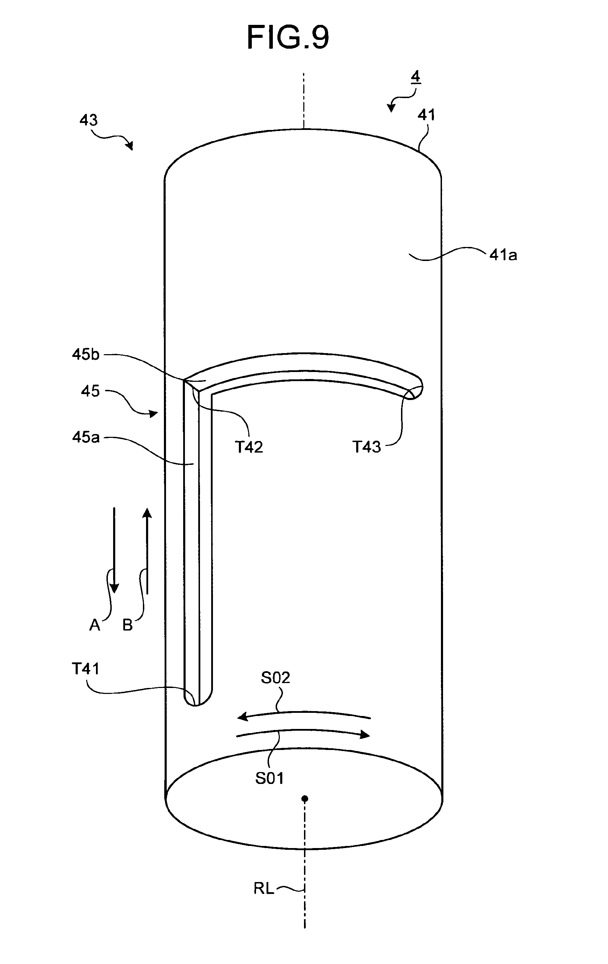

FIG. 9 is a perspective view schematically showing the guide slot of the fourth embodiment in an enlarged manner. The guide slot 45 is formed in the bearing shaft 41. The guide slot 45 is depressed from the outer circumference surface 41a of the bearing shaft 41 toward a pivot axis RL. The guide slot 45 is composed of an axial guide slot 45a as an axial portion of the guide means, and a circumferential guide slot 45b as a circumferential portion of the guide means. The axial guide slot 45a is formed in parallel to the pivot axis RL. The circumferential guide slot 45b is formed to extend in the circumferential direction of the bearing 42.

The axial and circumferential guide slots 45a and 45b of the guide slot 45 intersect with each other while they communicate with each other. The axial and circumferential guide slots 45a and 45b of the guide slot 45 are perpendicular to each other. In the casing 4 for a power conditioner, the pivotal movement of a door 11 about the pivot axis RL causes the bearing shaft 41 to pivot about the pivot axis RL. Thus, the guide slot 45 of the guide mechanism 43 formed in the bearing shaft 41 pivots about the pivot axis RL.

At that time, the pin 44 of the guide mechanism 43 attached to the bearing 42 does not pivot. However, in the guide mechanism 43, the movement of the guide slot 45 relative to the pin 44 results in the movement of the pin 44 relative to the guide slot 45. Hereinbelow, change of the position of the guide slot 45 relative to the pin 44 by the movement of the guide slot 45 is expressed as "movement of the pin 44 relative to the guide slot 45." A direction in which the pin 44 moves relative to the guide slot 45 when the door 11 is opened is defined as a pin pivoting direction S02. The circumferential guide slot 45b is formed to extend from the axial guide slot 45a toward the pin pivoting direction S02. The pin pivoting direction S02 is opposite to the door pivoting direction S01 shown in FIGS. 5 to 7.

A description will be given of the direction of mounting the guide mechanism 43. First, in the casing 4 for a power conditioner, the bearing shaft 41 is attached to the bearing 42 before the pin 44 is attached to the bearing 42. Next, in the casing 4 for a power conditioner, the position of the bearing shaft 41 inside the bearing 42 is determined such that the guide slot 45 formed in the outer circumference surface 41a of the bearing shaft 41 and the attachment hole 42b formed in the bearing 42 face each other. Then, in the casing 4 for a power conditioner, the pin 44 is screwed toward the pivot axis RL into the attachment hole 42b until the tip end of the pin 44 engages with the guide slot 45. As a result, the guide mechanism 43 is mounted to the casing 4 for a power conditioner.

The action and the effect of the guide mechanism 43 will next be described. A part of the guide slot 45 corresponding to a closed end portion of the axial guide slot 45a is defined as a first end portion T41. A part of the guide slot 45 corresponding to a portion at which the axial and circumferential guide slots 45a and 45b communicate with each other is defined as an intersecting portion T42. Further, a part of the guide slot 45 corresponding to a closed end portion of the circumferential guide slot 45b is defined as a second end portion T43. The first end portion T41 is formed farther from the rain shielding part 10f shown in FIG. 1 than the intersecting portion T42. The second end portion T43 is formed away from the intersecting portion T42 in the pin pivoting direction S02.

In the guide mechanism 43, the pin 44 engages with the guide slot 45 at the first end portion T41 while the door 11 is closed. If a user tries to move the door 11 pivotally about the pivot axis RL, since the pin 44 engages with the axial guide slot 45a in the casing 4 for a power conditioner, the movement of the pin 44 in the pin pivoting direction S02 is regulated by the axial guide slot 45a in the casing 4 for a power conditioner. As a result, the door 11 does not pivot about the pivot axis RL in the casing 4 for a power conditioner, whereby the casing 4 for a power conditioner can avoid interference between the door 11 and the rain shielding part 10f shown in FIG. 1.

A user applies force to the door 11 in a predetermined direction A in the direction of the pivot axis RL in order to open the door 11. At that time, the pin 44 moves relative to the guide slot 45 in a predetermined direction B along the axial guide slot 45a from the first end portion T41 toward the intersecting portion T42. The predetermined direction B is opposite to the predetermined direction A. In the casing 4 for a power conditioner, the pin 44 engages with the circumferential guide slot 45b when the pin 44 reaches the intersecting portion T42. This prevents the pin 44 from moving further relative to the guide slot 45 in the predetermined direction B. Accordingly, the casing 4 for a power conditioner can limit the amount of movement of the door 11 in the predetermined direction A.

Next, the user causes the door 11 to pivot about the pivot axis RL in the door pivoting direction S01. At that time, the pin 44 moves relative to the guide slot 45 along the circumferential guide slot 45b from the intersecting portion T42 toward the second end portion T43. In the casing 4 for a power conditioner, the second end portion T43 regulates the movement of the pin 44 in the pin pivoting direction S02 after the pin 44 reaches the second end portion T43. As a result, the casing 4 for a power conditioner can limit the amount of pivotal movement of the door 11 in the door pivoting direction S01.

As described above, the casing 4 for a power conditioner includes the axial guide slot 45a, and the circumferential guide slot 45b that is formed to extend in the pin pivoting direction S02 in which the pin 44 is caused to move relative to the guide slot 45 when the door 11 is opened. Accordingly, the casing 4 for a power conditioner guides the bearing shaft 41 first such that the door 11 is caused to move toward the predetermined direction A.

Next, in the casing 4 for a power conditioner, the circumferential guide slot 45b allows the pin 44 to move toward the opening direction S02. To be specific, the casing 4 for a power conditioner guides the bearing shaft 41 such that the door 11 can pivot toward the door pivoting direction S01. Thus, the casing 4 for a power conditioner can avoid interference between the door 11 and the rain shielding part 10f shown in FIG. 1. As described above, even if a casing for a power conditioner includes the rain shielding part 10f shown in FIGS. 1 and 2, a user can open and close the door 11 easily without the need of removing the door 11 completely from a casing body 10. Thus, a casing 5 for a power conditioner can eliminate the possibility of increased user's efforts for opening and closing the door 11.

The casing 4 for a power conditioner is provided with the guide mechanism 43, and accordingly, can regulate the amount of movement of the door 11 in the predetermined direction A. Thus, the casing 4 for a power conditioner can prevent the excessive movement of the bearing shaft 41 in the direction of the pivot axis RL. This can eliminate the possibility of collision of the door 11 with the ground, or of the bearing shaft 41 falling off the bearing 42, for example. Further, the casing 4 for a power conditioner is provided with the guide mechanism 43, and accordingly, can regulate the amount of pivotal movement of the door 11 in the door pivoting direction S01. Thus, in the casing 4 for a power conditioner, the maximum degree of opening of the door 11 can be set.

### Fifth Embodiment

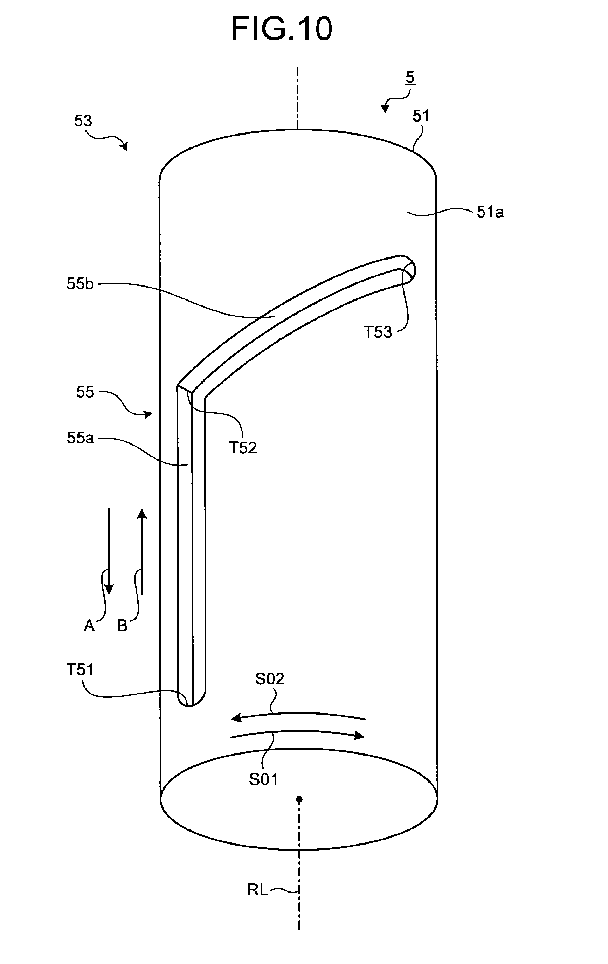

FIG. 10 is a perspective view schematically showing a guide mechanism of a fifth embodiment in an enlarged manner. A guide mechanism 53 of a casing 5 for a power conditioner according to the fifth embodiment includes a guide slot of a shape different from that of the guide mechanism 43 of the casing 4 for a power conditioner according to the fourth embodiment. As shown in FIG. 10, the guide mechanism 53 is composed of a pin 44, and a guide slot 55 as guide means in engagement with the pin 44. The guide slot 55 is formed in a bearing shaft 51. The guide slot 55 is depressed from the outer circumference surface 51a of the bearing shaft 51 toward a pivot axis RL.

The guide slot 55 is composed of an axial guide slot 55a as an axial portion of the guide means, and a circumferential guide slot 55b as a circumferential portion of the guide means. The axial guide slot 55a is formed in parallel to the pivot axis RL. The circumferential guide slot 55b is formed to extend in the circumferential direction of a bearing 42. The circumferential guide slot 55b is formed to be tilted relative to the axial guide slot 55a. The axial and circumferential guide slots 55a and 55b of the guide slot 55 intersect with each other while they communicate with each other. The circumferential guide slot 55b is formed to extend from the axial guide slot 55a toward a direction midway between a pin pivoting direction S02 and a predetermined direction B.

The action and the effect of the guide mechanism 53 will next be described. A part of the guide slot 55 corresponding to a closed end portion of the axial guide slot 55a is defined as a first end portion T51. A part of the guide slot 55 corresponding to a portion at which the axial and circumferential guide slots 55a and 55b communicate with each other is defined as an intersecting portion T52. Further, a part of the guide slot 55 corresponding to a closed end portion of the circumferential guide slot 55b is defined as a second end portion T53. The first end portion T51 is formed farther from the rain shielding part 10f shown in FIG. 1 than the intersecting portion T52. The second end portion T53 is formed away from the intersecting portion T52 in the pin pivoting direction S02, and is formed nearer the rain shielding part 10f than the intersecting portion T52.

In the guide mechanism 53, the pin 44 engages with the guide slot 55 at the first end portion T51 while a door 11 is closed. If a user tries to move the door 11 pivotally about the pivot axis RL, since the pin 44 engages with the axial guide slot 55a in the casing 5 for a power conditioner, the movement of the pin 44 in the pin pivoting direction S02 is regulated by the axial guide slot 55a in the casing 5 for a power conditioner. As a result, the door 11 does not pivot about the pivot axis RL in the casing 5 for a power conditioner, whereby the casing 5 for a power conditioner can avoid interference between the door 11 and the rain shielding part 10f shown in FIG. 1.

A user applies force to the door 11 in a predetermined direction A in the direction of the pivot axis RL in order to open the door 11. At that time, the pin 44 moves relative to the guide slot 55 along the axial guide slot 55a from the first end portion T51 toward the intersecting portion T52. In the casing 5 for a power conditioner, the pin 44 engages with the circumferential guide slot 55b when the pin 44 reaches the intersecting portion T52. This prevents the pin 44 from moving further relative to the guide slot 55 in the predetermined direction B. Accordingly, the casing 5 for a power conditioner can limit the amount of movement of the door 11 in the predetermined direction A.

Next, the user causes the door 11 to pivot about the pivot axis RL in a door pivoting direction S01. At that time, the pin 44 moves relative to the guide mechanism 53 along the circumferential guide slot 55b from the intersecting portion T52 toward the second end portion T53. At that time, the door 11 pivots about the pivot axis RL in the door pivoting direction S01 while the door 11 moves toward the predetermined direction A. The casing 5 for a power conditioner has the bottom plate 10c shown in FIG. 2 that is generally placed at the lower side of the vertical direction.

Accordingly, in the casing 5 for a power conditioner, the predetermined direction A is a direction toward the lower side of the vertical direction, and accordingly, the second end portion T53 is placed at an upper side than the intersecting portion T52 in the vertical direction. Thus, in the guide mechanism 53, the weight of the door 11 itself causes the guide slot 55 to move relative to the pin 44 in the predetermined direction A. Then, the pin 44 moves relative to the guide slot 55 toward the second end portion T53 while the pin 44 is guided along the circumferential guide slot 55b in the casing 5 for a power conditioner. As a result, the casing 5 for a power conditioner can open the door 11 without the need for the user to apply force to the door 11 for causing the door 11 to pivot in the door pivoting direction S01.

The intersecting portion T52 is placed at a lower side than the second end portion T53 in the vertical direction. Accordingly, in the casing 5 for a power conditioner, the pin 44 is pressed upward in the vertical direction against the second end portion T53 by the weight of the door 11 itself when the pin 44 reaches the second end portion T53. This allows the guide mechanism 53 to regulate the pivotal movement of the door 11 about the pivot axis RL. Accordingly, the guide mechanism 53 can eliminate the possibility of unintentional close of the door 11 while the door 11 is open for maintenance of a power conditioner by a user (operator).

### Sixth Embodiment

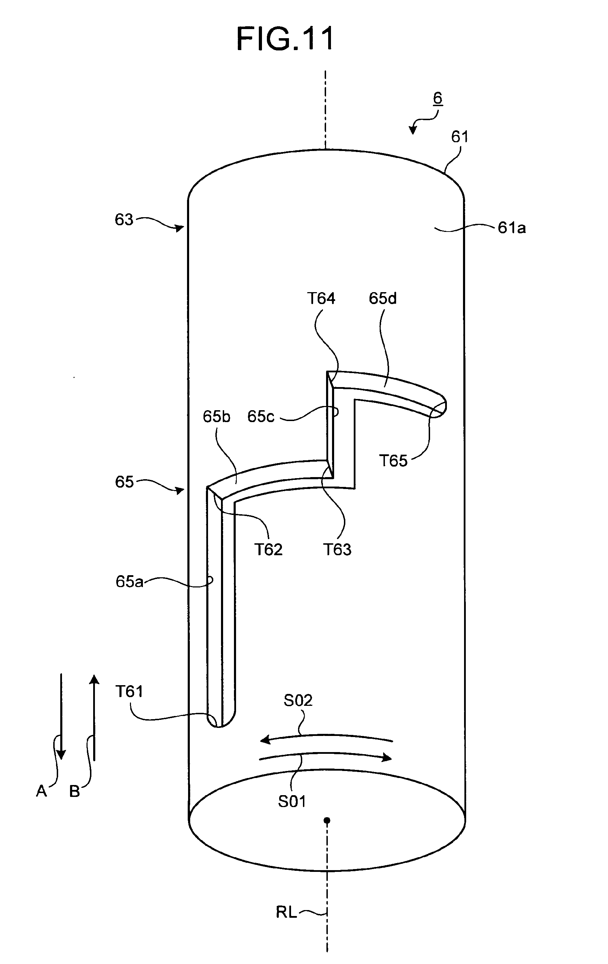

FIG. 11 is a perspective view schematically showing a guide mechanism of a sixth embodiment in an enlarged manner. A guide mechanism 63 of a casing 6 for a power conditioner according to the sixth embodiment includes a guide hole of a shape different from that of the guide mechanism 43 of the casing 4 for a power conditioner according to the fourth embodiment, and that of the guide mechanism 53 of the casing 5 for a power conditioner according to the fifth embodiment. As shown in FIG. 11, the guide mechanism 63 is composed of a pin 44, and a guide slot 65 as guide means in engagement with the pin 44. The guide slot 65 is formed in a bearing 42. The guide slot 65 is depressed from the outer circumference surface 61a of a bearing shaft 61 toward a pivot axis RL.

The guide slot 65 is composed of a first axial guide slot 65a as a first axial portion of the guide means, a first circumferential guide slot 65b as a first circumferential portion of the guide means, a second axial guide slot 65c as a second axial portion of the guide means, and a second circumferential guide slot 65d as a second circumferential portion of the guide means. The first and second axial guide slots 65a and 65c are formed in parallel to the pivot axis RL. The first and second axial guide slots 65a and 65c are formed at different positions in the circumferential direction of the bearing 42. In the present embodiment, the first and second axial guide slots 65a and 65c are formed in parallel to each other.

The first and second circumferential guide slots 65b and 65d are formed to extend in the circumferential direction of the bearing 42. The first and second circumferential guide slots 65b and 65d are formed at different positions in the direction of the pivot axis RL of the bearing 42. In the present embodiment, the first and second circumferential guide slots 65b and 65d are formed in parallel to each other. The first and second circumferential guide slots 65b and 65d are formed perpendicularly to the first and second axial guide slots 65a and 65c. Regarding the guide slot 65, one end of the first circumferential guide slot 65b communicates with the first axial guide slot 65a, and the other end of the first circumferential guide slot 65b communicates with the second axial guide slot 65c. Further, regarding the guide slot 65, one end of the second circumferential guide slot 65d communicates with the second axial guide slot 65c, and the other end of the second circumferential guide slot 65d is closed.

The action and the effect of the guide mechanism 63 will next be described. A part of the guide slot 65 corresponding to a closed end portion of the first axial guide slot 65a is defined as a first end portion T61. A part of the guide slot 65 corresponding to a portion at which the first axial guide slot 65a and the first circumferential guide slot 65b communicate with each other is defined as a first intersecting portion T62. A part of the guide slot 65 corresponding to a portion at which the first circumferential guide slot 65b and the second axial guide slot 65c communicate with each other is defined as a second intersecting portion T63. A part of the guide slot 65 corresponding to a portion at which the second axial guide slot 65c and the second circumferential guide slot 65d communicate with each other is defined as a third intersecting portion T64. Further, part of the guide slot 65 corresponding to a closed end portion of the second circumferential guide slot 65d is defined as a second end portion T65.

The first end portion T61 is formed farther from the rain shielding part 10f shown in FIG. 1 than the first intersecting portion T62. The second intersecting portion T63 is formed away from the first intersecting portion T62 toward the pin pivoting direction S02. The third intersecting portion T64 is formed nearer the rain shielding part 10f than the second intersecting portion T63. The second end portion T65 is formed away from the third intersecting portion T64 in the pin pivoting direction S02.

In the guide mechanism 63, the pin 44 engages with the first axial guide slot 65a at the first end portion T61 while a door 11 is closed. If a user tries to move the door 11 pivotally about the pivot axis RL, since the pin 44 engages with the first axial guide slot 65a in the casing 6 for a power conditioner, the movement of the pin 44 in the door pivoting direction S01 is regulated by the first axial guide slot 65a in the casing 6 for a power conditioner. As a result, the door 11 does not pivot about the pivot axis RL in the casing 6 for a power conditioner, whereby the casing 6 for a power conditioner can avoid interference between the door 11 and the rain shielding part 10f shown in FIG. 1.

A user applies force to the door 11 in a predetermined direction A in the direction of the pivot axis RL in order to open the door 11. At that time, the pin 44 moves relative to the guide slot 65 along the first axial guide slot 65a from the first end portion T61 toward the first intersecting portion T62. In the casing 6 for a power conditioner, the pin 44 engages with the first circumferential guide slot 65b when the pin 44 reaches the first intersecting portion T62. Next, the user causes the door 11 to pivot about the pivot axis RL in the door pivoting direction S01. Accordingly, the pin 44 moves relative to the guide slot 65 along the first circumferential guide slot 65b from the first intersecting portion T62 toward the second intersecting portion T63. At that time, as the door 11 has moved in the predetermined direction A, the casing 6 for a power conditioner avoids interference of the door 11 with the rain shielding part 10f as shown in FIG. 2.

In the guide mechanism 63, the pin 44 engages with the second axial guide slot 65c when the pin 44 reaches the second intersecting portion T63. Then, the pin 44 moves relative to the guide slot 65 along the second axial guide slot 65c from the second intersecting portion T63 toward the third intersecting portion T64. At that time, the weight of the door 11 itself applies force in the vertical direction to the bearing shaft 61. Accordingly, in the guide mechanism 63, the pin 44 is caused to move relative to the guide slot 65 in the predetermined direction B. The user causes the door 11 to pivot about the pivot axis RL in the door pivoting direction S01 after the pin 44 reaches the third intersecting portion T64. At that time, the pin 44 moves relative to the guide slot 65 along the second circumferential guide slot 65d from the third intersecting portion T64 toward the second end portion T65. This causes the door 11 to pivot about the pivot axis RL in the door pivoting direction S01.

In the casing 6 for a power conditioner of the aforementioned structure, the movement of the pin 44 in the circumferential direction is regulated at the second end portion T65 and the third intersecting portion T64 when the pin 44 engages with the second circumferential guide slot 65d, namely while the door 11 is open. This allows the guide mechanism 63 to regulate the pivotal movement of the door 11 about the pivot axis RL between the third intersecting portion T64 and the second end portion T65. Accordingly, the guide mechanism 63 can eliminate the possiblity of unintentional close of the door 11 while the door 11 is open for maintenance of a power conditioner by a user (operator).

### Industrial Applicability

The casing for a power conditioner according to the present invention is useful as a casing placed in the open air. More specifically, the casing for a power conditioner according to the present invention is applied suitably for reducing user's efforts for opening and closing a door.

### Reference Signs List

10 CASING BODY
10a BACK PLATE
10b TOP PLATE
10c BOTTOM PLATE
10d SIDE PLATE
10e OPENING
10f RAIN SHIELDING PART
11 DOOR
1, 2, 3, 4, 5, 6 CASING FOR A POWER CONDITIONER
13, 41, 51, 61 BEARING SHAFT
13a, 41a, 51a, 61a OUTER CIRCUMFERENCE SURFACE
14, 22, 32, 42 BEARING
14a, 42a INNER CIRCUMFERENCE SURFACE
14b CLEARANCE
15, 23, 33, 43, 53, 63 GUIDE MECHANISM
16, 44 PIN
17, 25, 35 GUIDE HOLE
17a, 25a AXIAL GUIDE HOLE
17b, 25b CIRCUMFERENTIAL GUIDE HOLE
35a FIRST AXIAL GUIDE HOLE
35b FIRST CIRCUMFERENTIAL GUIDE HOLE
35c SECOND AXIAL GUIDE HOLE
35d SECOND CIRCUMFERENTIAL GUIDE HOLE
42b ATTACHMENT HOLE
45, 55, 65 GUIDE SLOT
45a, 55a AXIAL GUIDE SLOT
45b, 55b CIRCUMFERENTIAL GUIDE SLOT
65a FIRST AXIAL GUIDE SLOT
65b FIRST CIRCUMFERENTIAL GUIDE SLOT
65c SECOND AXIAL GUIDE SLOT
65d SECOND CIRCUMFERENTIAL GUIDE SLOT
A, B PREDETERMINED DIRECTOIN
RL PIVOT AXIS
S01 DOOR PIVOTING DIRECTION
S02 PIN PIVOTING DIRECTION
T11, T21, T31, T41, T51, T61 FIRST END PORTION
T12, T22, T42, T52 INTERSECTING PORTION
T13, T23, T35, T43, T53, T65 SECOND END PORTION
T32, T62 FIRST INTERSECTING PORTION
T33, T63 SECOND INTERSECTING PORTION
T34, T64 THIRD INTERSECTING PORTION

## Claims

1. A casing for a power conditioner, comprising:
a casing body with an opening, the casing body housing units of a power conditioner;
a door attached to the casing body, the door being capable of covering the opening;
a bearing shaft provided to any of the casing body and the door;
a bearing provided to any of the casing body and the door to which the bearing is not provided, the bearing covering at least a part of an outer circumference surface of the bearing shaft, the bearing supporting the bearing shaft such that the bearing shaft can pivot about a pivot axis of the bearing shaft and can move in a direction of the pivot axis;
a projection provided to one of the bearing shaft and the bearing, the projection projecting toward the other one of the bearing shaft and the bearing; and
a guide means provided to any of the bearing shaft and the bearing to which the projection is not provided, the guide means being in engagement with the projection,
the guide means including:
an axial portion formed in the direction of the pivot axis; and
a circumferential portion formed to extend in a circumferential direction of any of the bearing shaft and the bearing in which the guide means is formed and to intersect with the axial portion, the circumferential portion allowing the projection to move relative to the guide means in the circumferential direction when the door is opened.

2. The casing for a power conditioner according to claim 1, wherein the circumferential portion and the axial portion of the guide means are perpendicular to each other.

3. The casing for a power conditioner according to claim 1, wherein the circumferential portion and the axial portion of the guide means intersect with each other while the circumferential portion is tilted relative to the axial portion.

4. The casing for a power conditioner according to any one of claims 1 to 3, wherein
the axial portion includes
a first axial portion, and
a second axial portion formed at a different position from the first axial portion in the circumferential direction, and
the circumferential portion includes
a first circumferential portion with one end thereof communicating with the first axial portion and the other end thereof communicating with the second axial portion, and
a second circumferential portion formed at a different position from the first circumferential portion in the direction of the pivot axis, the second circumferential portion communicating with the second axial portion.

5. The casing for a power conditioner according to any one of claims 1 to 4, wherein
the guide means guides movement of the door in the direction of the pivot axis by allowing the projection to engage with the axial portion when the door covers the opening, and
the guide means allows pivotal movement of the door about the pivot axis by allowing the projection to engage with the circumferential portion after the projection moves relative to the guide means toward the circumferential portion.
